# EUROPEAN PATENT SPECIFICATION

(11) **EP 1 856 728 B1**
(45) Date of publication and mention of the grant of the patent: **22.10.2008**
(21) Application number: 06710970.2
(22) Date of filing: 27.02.2006
(51) Int. Cl.: H01L 21/60, H01L 23/498, H01L 23/538

(54) **A METHOD OF MANUFACTURING SEMICONDUCTOR PACKAGES AND PACKAGES MADE**
HERSTELLUNGSVERFAHREN FÜR HALBLEITERGEHÄUSE UND MIT DIESEM VERFAHREN HERGESTELLTE GEHÄUSE
PROCEDE DE FABRICATION D'UN BOITIER DE SEMICONDUCTEUR ET BOITIERS REALISES

(30) Priority: 02.03.2005 EP 05101593
(43) Date of publication of application: 21.11.2007
(73) Proprietor: Koninklijke Philips Electronics N.V., 5621 BA Eindhoven (NL)
(72) Inventor: VAN VEEN, Nicolaas, J., A., NL-5656 AA Eindhoven (NL); DEKKER, Ronald, NL-5656 AA Eindhoven (NL); TAK, Coen, C., NL-5656 AA Eindhoven (NL)
(74) Representative: Schouten, Marcus Maria
(86) International application number: PCT/IB2006/050599
(87) International publication number: WO 2006/092754

(56) References cited:
- EP-A2- 0 588 603
- EP-A2- 1 418 617
- WO-A-20/05117096
- US-A- 5 048 179
- US-A- 5 386 623
- US-A1- 2004 046 254
- US-A1- 2005 056 903
- US-B1- 6 242 282
- US-B1- 6 720 270
- US-B2- 6 753 238

## Description

The invention relates to a flexible semiconductor package with a first and a second side, between which sides a semiconductor device is present having a thinned back substrate and an interconnect structure, at which first side contact means for external contact and a first resin layer are present, which contact means are coupled to the interconnect structure, and at which second side the semiconductor device is at least substantially covered with a second resin layer, wherein the contact means are present on the first resin layer and are coupled to the interconnect structure with redistribution tracks extending in apertures through the first resin layer, and a passivation layer covers the first resin layer and the redistribution tracks at least substantially.

The invention also relates to a method of manufacturing a plurality of semiconductor packages comprising the steps of:
- providing a wafer with a substrate side and an opposite, interconnect side and with a plurality of semiconductor devices, that are provided with an interconnect structure at the interconnect side;
- applying a resin layer on the interconnect structure;
- attaching the wafer with its first side to a carrier with an adhesive agent;
- thinning the wafer from the second side;
- applying another resin layer on the second side of the wafer, and
- removing at least some of the thus formed semiconductor packages from the carrier,
wherein contact means are defined on a first of the resin layers that are coupled to the interconnect structure with redistribution tracks extending through apertures in this first resin layer and that a passivation layer is applied on the first resin layer and the redistribution tracks.

EP1418617 relates to a method of manufacturing a semiconductor device, which comprises the steps of preparing a wiring substrate having a wiring pattern on a surface, bonding a connection terminal of an electronic chip, which has a predetermined element and the connection terminal on one surface, to the wiring pattern of the wiring substrate by a flip-chip bonding, forming an insulating film on the wiring substrate to have a film thickness that exposes at least another surface of the electronic chip, and reducing a thickness of the electronic chip by grinding said other surface of the electronic chip and the insulating film.

Such a method and such a device are known from US-B 6,753,238. In the known method, bumps are applied to the interconnect structure which is exposed by contact holes through a passivating film. Bumps are applied hereon with a height of 20 to 40 microns, and any space between the bumps is filled up with a resin layer of a thermosetting resin, such as an epoxy. This is given the same thickness in order to have a planar surface. The wafer is then bonded to the carrier with the adhesive agent using a thermocompression bonding method. This carrier is a porous aluminate plate. In order to remove this plate, the wafer is immersed into a bath of an organic solution at elevated temperature, in order to dissolve the adhesive agent. The second resin layer may be applied in the same thickness as the first resin layer. Alternatively, use can be made of ultraviolet rays to irradiate a transparent carrier, after which the semiconductor package may be peeled off from the adhesive agent.

It is a disadvantage of the known device, particularly for very thin packages, that it is vulnerable to crack formation.

It is therefore a first object of the invention to provide a package of the kind mentioned in the opening paragraph with reduced risk of crack formation.

This object is therein achieved that the redistribution tracks do not fill the apertures of the first resin layer. Suitably, the second of the resin layers is covered with a passivation layer.

The vulnerability of crack formation of the known device particularly results from differences in thermal expansion between the package and a printed circuit board to which it is attached with the bumps. These bumps are thus of primary importance for the compensation. They are however highly integrated in the known package, such that any stress is transferred from the bumps to the interconnect structure and hence to the device. This rigid part of the package is however the most vulnerable part. In the construction of the invention, the resin layer effectively functions as a stress barrier that may relaxate the stresses resulting from the differences in thermal expansion.

The contact means in the device of the invention are preferably contact pads, to which bumps of solder or metal or conductive glue may be applied. However, it is not excluded that the contact means are an antenna for contactless coupling, such as a coil, a dipolar antenna or even a capacitor plate.

Additionally, in combination with the presence of contact means on top of the resin layer, it turned out necessary to apply a passivation layer. That has several functions. First, the passivation layer acts as a solder mask. Secondly, the passivation layer protects the redistribution tracks. In view of the thickness of the resin layer, which is in the order of several microns, apertures therein have more or less the shape of an inverse cone, or in cross-sectional view are U-shaped or V-shaped. This leads thereto that the redistribution tracks are present only at the sidewall of the cone, but do not fill it. This non-filling is suitable in view thereof that the matching of the coefficients of thermal expansion is less critical. However, particularly with a flexible package, the apertures may develop into mechanically and chemically weak points, at which cracks may be initiated or at which contamination may enter the package. The passivation layer that extends on these tracks forms a continuous foil, and provides thus both chemical and mechanical protection.

A package with redistribution tracks on top of a resin layer is known per se from US6,506,664, particularly Fig. 7 and the related description therein. However, the known device is not present between a first and a second resin layer so as to be put under compressive strain. That turns out necessary to prevent the formation of cracks during separation processes and in bending. In view thereof that the package is used as part of a stack, it appears that the resulting stack does not have a high level of flexibility, and hence has other mechanical behaviour than the flexible package of the invention. This is also apparent in that the known package includes filled vertical interconnects through the resin layer while a passivation layer is absent.

A package of the type of the invention is further described in the non-prepublished application PCT/IB 2004/0516 (PHNL031150). However, it is herein not disclosed that the oxide layer on the resin layer is patterned so as to expose the contact pads, and that it may function as a passivation layer. Moreover, it is not disclosed that the passivation layer could be an oxynitride or a nitride, which is advantageous for the passivating properties.

In a preferred embodiment, the second of the resin layers is covered with a passivation layer as well. This is particularly preferred, in that the second side may be suitably provided with contact pads as well. This leads, for instance, to a package that is stackable. Another option is the provision of an inductor, an (other) antenna or a capacitor on the second resin layer. However, the presence of a passivation layer is also advantageous without the presence of any conductor tracks on the second resin layer. Particularly, the passivation layer protects the resin layer against the adhesive. Hence, release of the thinned package from the carrier becomes easier.

In one embodiment, the semiconductor device is provided with a substrate side and an interconnect side, at which substrate side a semiconductor substrate is present and at which interconnect side the interconnect structure is present, and wherein said first resin layer is present at the substrate side and said second resin is present at the interconnect side. Whereas in the prior art, the bumps are present at the interconnect side of the device, the construction of the invention allows the use of the substrate side of the device for the provision of the bumps. This has the advantage that during manufacture the bumps do not need to be covered by the adhesive layer. The presence of bumps requires a thicker adhesive layer and requires the cleaning of the bumps afterwards. The adhesive layer attaches the package with a temporary carrier, which is usually a glass plate. This temporary carrier is needed for stability during the thinning of the semiconductor substrate.

Suitably, the resin layer is a material with a glass transition temperature above the melting temperature of the solder. For a leadfree solder, this melting temperature is about 270 °C.

Particularly suitable materials are epoxies and polyimides. Polyimides are polymeric resins that comprise aromatic groups and the acidic imide group. Examples of polyimide polymers are the polyimides, polyisoimides, maleinimides, bismaleinimides, polyamideimides, polymidimides, polyetherimides, and polyimide-isoindoloquinazolinedionimide.

Suitably, the passivation layer comprises an inorganic material. Chemical vapour deposition, and particularly Phase Enhanced Chemical Vapour Deposition (PECVD) is considered to be effective and to provide a passivation layer with a good adhesion to the underlying materials. Additionally, the PECVD technique allows deposition in at a temperature below the glass transition temperature of the resin. Most suitable materials are silicon oxide, oxynitride and silicon nitride.

The inorganic passivation layer is particularly useful in combination with polyimide resins. One disadvantage of polyimides is their relatively weak adhesion to metals. The inorganic passivation layer of the invention has a relatively good adhesion to the polyimide. Its apertures are provided such that the redistribution tracks and the contact pads are exposed only partially. Hence, the contact pads are sandwiched at their edges between the resin layer and the passivation layer. This effectively anchors the metal. Therewith the stability of the overall package is improved substantially.

In a further embodiment, the semiconductor device is provided with a substrate having an insulating layer, and the passivation layers extend adjacent to and/or in apertures in the respective resin layer up to the insulating layer, therewith forming a hermetic enclosure of the semiconductor device. Many resin layers that have suitable elastic properties, are not adequate in the protection of the semiconductor device against contaminants and/or humidity. This is particularly true for the polyimides, that tend to absorb water. With the hermetic enclosure of the passivation layer, the device is adequately protected. The insulating layer in the substrate may be a layer that originally was buried in the substrate. However, it may be as well a thermal oxide layer that is provided as the top layer of the substrate, and generally known in the field (LOCOS).

Advantageously, one of the resin layers extends to a lateral side face of the package. Suitably, the second resin layer is patterned for the definition of separation lanes. This is advantageous, as it allows the removal of any substrate portion or ceramic layer in the separation lane with the help of etching. If this removal were carried out with sawing, the saw through several materials led to the introduction of additional stresses in the package. In order to stabilize the package and protect it mechanically and chemically, the second passivation layer was found helpful.

In an advantageous modification hereof, the said resin layer is provided with rounded edges. Such rounded edges are easily provided in that the resin layer is patterned in an etching treatment or an optical ablation treatment, such as laser ablation. The presence of rounded edges prevents crack initiation at the corners. It is particularly preferred that the packages are separated from each other by sawing or cutting through the first resin layer. This leads thereto that the first resin layer extends laterally beyond the second resin layer.

In another modification at least one contact pad is present on the second resin layer and is exposed through an aperture in the passivation layer. The patterning of the second resin layer and the provision of a second passivation layer enables the provision of one or more contact pads at the second side of the package, without much additional processing. The provision of contact pads on the second side enables stacking in an easy manner. Additionally, the package may be used as a carrier itself for further ICs, or be provided as a label to any surface of an electronic device with suitable contacts.

The package of the invention may be suitably used as a stack with a plurality of packages of devices. There is no need, in this context, that all packages in the stack have the same size.

The package of the invention may further be used as a label in flexible devices. It may be used as a display driver on a rollable or otherwise flexible display. It may be used for security purposes in security paper, particularly by application to a security thread or other tape. It may be used for identification in medical applications, particularly within the human body.

It is a second object of the invention to provide a method of manufacturing of the kind mentioned in the opening paragraph for the device of the invention.

This object is achieved in that the redistribution tracks do not fill the apertures of the first resin layer.

The method of the invention leads to the device of the invention and may be applied with a number of interesting embodiments.

The redistribution tracks extending through the first resin layer are preferably defined in one layer. Preferably the contact pads are defined in this same layer. However, in principle the tracks through the first resin layer and that on the first resin layer could be applied separately.

The passivation layer suitably comprises an inorganic material. Advantageous deposition techniques are low-pressure and phase enhanced chemical vapour deposition, leading to dense layers and carried out at reduced temperatures. It is not excluded that the passivation layer comprises several sublayers.

The exposure of the contact pads does not exclude that the passivation layer partially covers in the contact pad, so that it is 'resist defined'. The 'resist defined' contact pad is even particularly suitable for a proper function of the passivation layer.

Suitably the contact pads are thickened by application of a suitable material, particularly a metal or an alloy. Most suitably is the use of nickel. This metal can be applied in an electroless technique as is known per se to the skilled person.

It is advantageous that the solder applied on the contact pads is in the form of solder caps. The term 'solder caps' refers, in the context of this application, thereto that the solder dot encloses with the underlying surface an angle of less than 90 °. Such solder caps are advantageous for use in an inherently thin package of the invention, since the caps have a limited height as well. The term 'inherently thin package' is particularly a package that has a thickness, without bumps, of preferably less than 100 microns, and suitably even less. Moreover, the solder caps are very suitable, if the solder caps must be covered with an adhesive layer and a carrier. The surface area of the solder caps is smaller than that of conventional solder droplets, leading to a reduction of the interface area between solder and adhesive. The reduced height simultaneously reduces the needed thickness of the adhesive layer.

The solder caps on the package of the invention are very suitable so as to connect the package with another package. For such stacking connection, the solder does not have the function of bridging substantial differences in thermal expansion. However, for such an inherently chip-scaled connection the pitch - the distance between neighbouring contact pads - is preferably small. This small pitch is enabled by the solder caps. Use of the solder caps at a side not covered by the adhesive or for connection to an external board is however not excluded. Furthermore, the bumps could be applied at the end of the manufacturing.

A suitable technique for the provision of solder caps is the use of immersion soldering.

In again another aspect the invention relates to an intermediate product. As mentioned before, the invention offers the division of both resin layers to provide individual packages in different manners: the resin layer on the second, substrate side of the wafer is suitably individualized by an etching technique, while the other resin layer can afterwards be divided by a standard separation technique, such as sawing or cutting. The intermediate product is the product in which the other resin layer at the first, interconnect side of the device has not yet been divided. It appears that this intermediate product constitutes an easy form for transport of the packages from its manufacture to a customer.

If so desired, the continuous resin layer may contain holes, and particularly a pattern of holes on a separation lane. These holes then define adequately the separation lines for a customer. Moreover, the division of the resin layer may be carried out with a very simple separation technique, such as breaking.

The intermediate product may be present on a carrier, such as a glass plate or a separation foil that is known per se in the art. However, this is not necessary, in which case the intermediate product may be rolled up. Preferably, the intermediate product is provided with solder bumps, but even this is not needed. If present, the solder bumps are suitably provided as solder caps. The presence of the solder in the form of caps is understood to reduce the risk of damaging the solder during handling and transport.

The intermediate product is preferably provided with a marking. Such marking may be applied, for instance, in an area outside the individual devices.

These and other aspects of the package, the method and the intermediate product of the invention will be further explained with reference to the drawings, that are purely diagrammatical and not drawn to scale, and in which like reference numerals in different figures refer to equal parts, in which:
Figs. 1 to 6 show cross-sectional views of the steps in the method;
Fig. 7 shows a cross-sectional view of the package in a first embodiment;
Fig. 8 shows a cross-sectional view of the package in a second embodiment, at the stage of the intermediate product as adhered to a carrier;
Fig. 9 shows a cross-sectional view of the package in a third embodiment, at the stage of the intermediate product and
Fig. 10 shows a cross-sectional view of the package in a fourth embodiment, at the stage of the intermediate product.

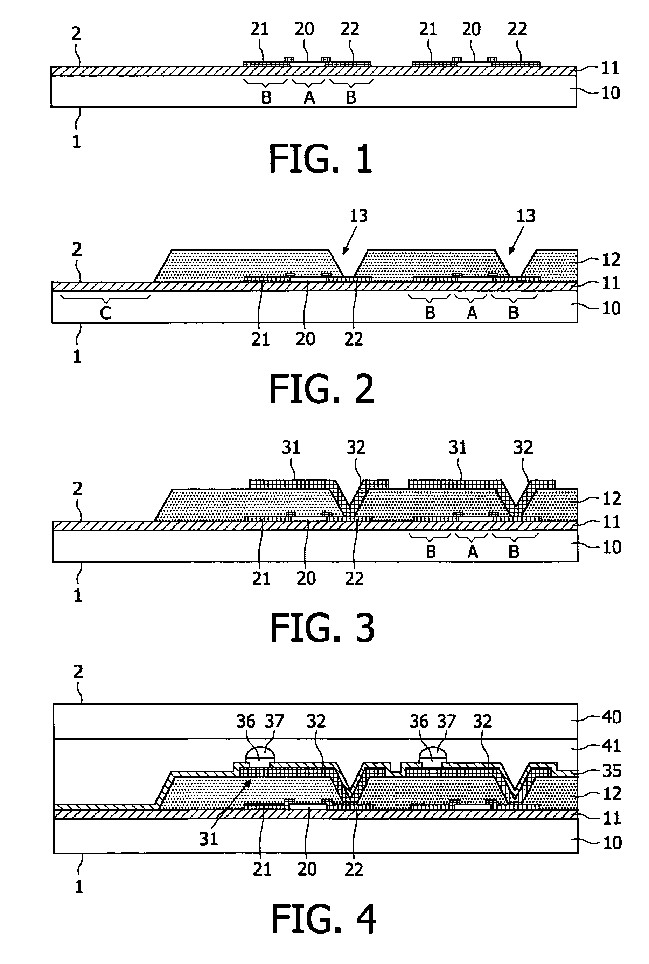

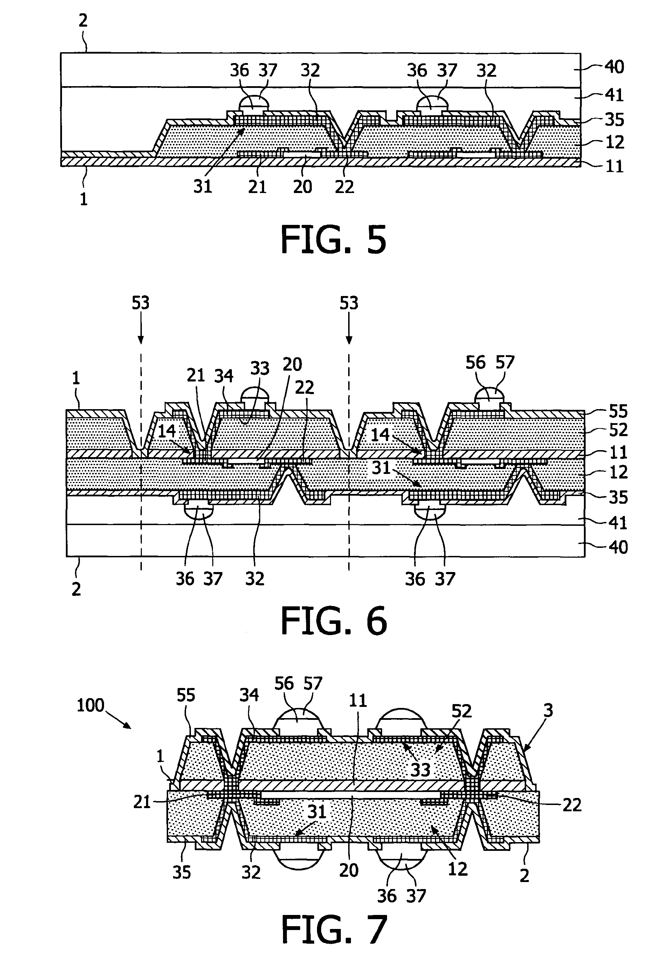

Figs. 1 to 6 relate to a first embodiment of the method of manufacturing a package according to the invention. The resulting device is shown in Fig. 7. Although merely one or two contact pads per device are shown, it is to be understood that a plurality thereof may be present.

In this example, use is made of a semiconductor substrate 10 in which an insulating layer 11 is buried. The buried layer 11 is typically an oxide layer, but may include a nitride layer for improved chemical protection of the integrated circuit 20, which is provided in and on a surface layer of a semiconductor material that is generally epitaxially grown. The semiconductor material of the substrate 10 and the surface layer are in this case silicon, but the surface layer could be alternatively another semiconductor material, such as GaAs or GaN. The buried insulating layer 11 is used in the process as an etch stop layer. Alternatively, an p-n junction may be used as an etch stop layer. In another example, not shown here, use is made of a conventional substrate, with an thermal oxide thereon, that is commonly made by local oxidation of silicon (LOCOS). Semiconductor devices may then be defined for instance in a thin-film technology on the oxide. These devices may be applied as well in the substrate, such as for instance in CMOS or BICMOS technology. During the etching treatment, portions of the semiconductor substrate are then kept as mesa-structures.

In this example, the semiconductor device is an integrated circuit with a plurality of semiconductor elements. This is particularly suitable for use for identification purposes. However, the semiconductor device may alternatively comprise diodes, such as light-emitting diodes or diodes for electrostatic discharge protection. In a further embodiment, such a semiconductor device comprises a sensor, such as a temperature sensor or any other device as desired for medical applications. In such applications, the device is preferably provided with an antenna for wireless transmission of data. This antenna may be present on one of the resin layers.

The integrated circuit 20 comprises a plurality of semiconductor elements (non-shown) in an active area A. The elements are mutually interconnected according to a desired pattern in an interconnect structure (not specifically shown). The structure comprises a first via pad 21 and a second via pad 22, which pads 21,22 are present in an area B that is laterally substantially outside the active area A. The via pads are preferably provided in a layer of aluminum in view of its ductility. However, Cu, Ni, Ag or a conductive paste could be used alternatively.

Fig. 2 shows the result after a - second - resin layer 12 has been applied at the second side 2. In this case use is made of polyimide in a typical thickness of 10 to 20 µm. Before applying the polyimide, for instance by spincoating, the surface has been cleaned and a primer layer has been provided for improved adhesion. After the application of the polyimide, it is heated first to 125 °C and thereafter to 200 °C. Then a photoresist is applied, exposed to a suitable source of radiation and developed. The development includes the structuring of the polyimide layer, so as to create contact windows 13 that expose the second via pads 22. The second resin layer 12 of polyimide is removed as well in an edge area C of the substrate, typically a 6" wafer. The removal of the support layer 13 in the edge area C has an beneficial effect on the yield.

Fig. 3 shows the result, after an electrically conducting layer has been provided at the second side 2 of the substrate 10. The electrically conducting layer is applied in a pattern that comprises a contact pad 31 and a conducting tracks 32 extending through the resin layer 12 to the second via pad 22. The electrically conductive layer may contain Al or an alloy based on Al. This, in combination with the use of Al for the second via pad 22 provides a good electrical connection and has the required flexibility to withstand any bending of the foil and any forces during lamination of the device into a label. Alternatively, other materials are used on the basis of electroplating. The first step in this process is the provision of a base layer by sputtering. This base layer is usually not patterned and very thin. Then, a photoresist is applied and patterned according to the desired pattern of contact pads and conducting tracks. This is followed by electroplating of copper, in a thickness of for instance 0.5-1.3 microns. Finally, the photoresist is removed and the plating base is etched away.

Fig. 4 shows the substrate 10 after it has been attached to a carrier 40 with removable attaching means 41. This means 41 is in this case a layer of adhesive, which is releasable upon irradiation with UV-radiation. Thereto, the carrier 40 is transparant, and in this example a layer of glass.

Before application to the carrier 40, the electrically conducting tracks 32 and the resin layer 12 are covered with a passivation layer 35. The passivation layer 35 is in this case silicon nitride and is deposited by PECVD at a temperature of about 250 ° C, in a thickness of approximately 0,5-1,0 micron. Thereafter, the passivation layer 35 is patterned to expose the contact pads 31. The passivation layer 35 partly extends on the contact pads 31, and functions as a 'resist defined' solder mask. The contact pad 31 is thereafter strengthened by deposition of an under bump metallization 36. In this example, the under bump metallization 36 comprises nickel and is deposited electroless in a thickness of 2-3 microns. This treatment has the advantage, that no additional mask is needed for the provision of the under bump metallization 36. Alternatively, copper can be used for the under bump metallization 36 and be applied by electroplating. In this case, the under bump metallization 36 and a galvanic bump 37 may be applied in one step. Due to its thickness the under bump metallization 36 extends over the passivation layer 35.

Finally, a bump 37 is applied on the under bump metallization 36. In this example, the bump 37 is a solder cap of Sn, SnBi or PbSn, and is applied by immersion into a bath of the desired composition. However, if this under bump metallization 36 is immersed in a bath of pure tin at a temperature of approximately 250 °C, then NiSn intermetallics may be formed. And they are formed in the form of needles that protrude through the bump surface. This does not give a useful result. The formation of these intermetallics can be prevented through the use of a low-melting Sn-alloy. Examples of such alloys include SnPb, SnCu and SnBiₓIn_{y}Zn_{z}, wherein at least one of x, y and z is larger than zero. Preferably, a lead-free solder is applied. Advantageously, the alloying elements do not interfere in the reaction between Sn and the metal of the metallization - particularly Au.

In an advantageous modification, the nickel under bump metallization is provided with a gold adhesion layer before the immersion into the bath. Such a gold adhesion layer is needed for the maintenance of the solderability. However, it has been found that such a gold layer is not needed when the immersion step is carried out directly after the provision of the nickel under bump metallization.

Fig. 5 shows the result after the substrate 10 has been thinned from the first side. This thinning is usually achieved with grinding and continued etching with KOH. The buried layer 11 acts herein as the etch stop layer.

Fig. 6 shows the result after a number of further steps. These steps are similar to the steps on the second side 2 of the substrate 10, and comprise the provision of a first resin layer 52; the provision of an electrically conducting layer comprising contact pads 33 and conducting tracks 34 extending through the first resin layer 52; the provision of a passivation layer 55, the provision of an under bump metallization 56 and the provision of bumps 57.

One important difference is the patterning of the buried oxide layer 11 so as to create contact windows 14 to the via pads 21. This patterning of the buried oxide layer 11 is suitably carried out after the provision of the resin layer 52. The resin layer 52 herein acts as the etching mask. Preferably in the same patterning step, the resin layer 52 and the buried oxide layer 11 are patterned to create separation lanes 53. This is carried out in such a manner that the first resin layer 52 gets rounded edges. The conducting tracks are thereafter provided so as to fill the apertures in the first resin layer 52 and the buried oxide 11 that give access to the via pad 21, but not in the separation lanes 53. The passivation layer 55 is deposited in the separation lanes. This provides a passivating surface to the first resin layer 52, extending on all sides of the resin layer 52 up to the buried oxide layer 11.

Fig. 7 shows the package 100 of the invention in a first embodiment. The device 100 comprises a first contact pad 33 and a second contact pad 31, as well as an integrated circuit 20. The integrated circuit 20 is present between a first and a second resin layer 52,12 that put the circuit under compressive strain so as to minimize crack formation. Conducting tracks 32, 34 extends through resin layers 12,52 respectively to via pads 21,22. In this example, the conducting tracks 32,34 are connected to the same via pad 21, 22, leading to a package that can be applied from two sides 1,2. However, this is an example only, and it will be clear that in practice the conducting tracks 32,34 are displaced with respect to each other. The conducting tracks 32,34 end up at contact pads 31, 33, which are exposed partially ('resist defined pads') through passivation layers 35,55. The contact pads 31,33 are strengthened with under bump metallizations 36,56 and provided with bumps 37, 57, in this case solder caps. The passivation layer 55 also extends at a lateral side face 3 of the package 100 up to insulating layer 11. The other resin layer at the second side 2 of the package 100 is separated using conventional separation technology such as sawing or cutting.

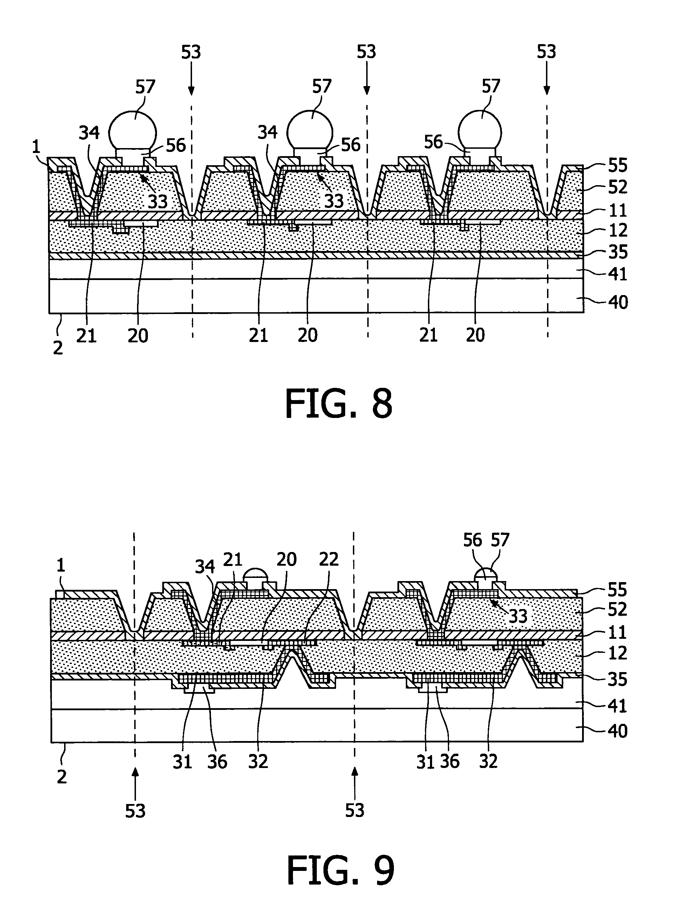

Fig. 8 shows a second embodiment of the package 100. In this figure, in fact the intermediate product 200 is shown, in the situation that it is still attached to the carrier 40. A first feature of this embodiment that at the second side 2 of the package no contact pads are defined. The resin layer 12 is simply covered with a passivation layer 35. The first resin layer 52 is present at the first side 1 of the package 100, and contact pads 34 and conducting tracks 33 are defined thereon, said conducting tracks 33 eaxtending through the first resin layer 52. The bumps 57 are in this example conventional bumps, such as those of Pb-Sn or of SAC-solder (Sn-Ag-Cu). Separation lanes 53 are defined with apertures in the first resin layer 52. The intermediate product 200 can be divided into individual packages by dividing the second resin layer 12. This can be done before or after release of the product 200 from the carrier 40. If the separation step is carried out afterwards, the intermediate product 200 is suitably transferred to a separation foil before division of the resin layer 12.

Fig. 9 shows a third embodiment of the package, again at the stage of the intermediate product 200 attached to the carrier 40. This embodiment is structurally identical to that of the first embodiment shown in Fig. 6. The difference is that no solder is applied on the under bump metallization 36 on the contact pads 31 at the second side 2. This is suitable for the release of the product 200 from the carrier. Moreover, if the package 200 is stacked to an assembly with a further package, a single amount of solder is sufficient.

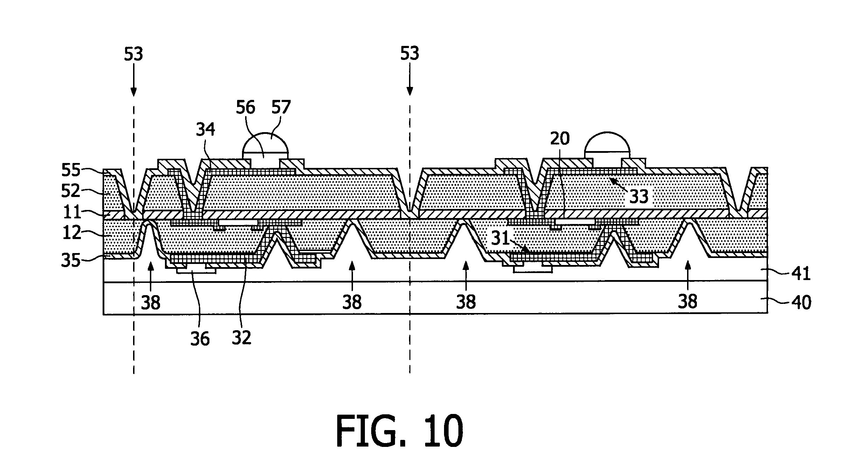

Fig. 10 shows a fourth embodiment of the package, again at the stage of the intermediate product 200 that is attached to the carrier 40. In this embodiment, the integrated circuit 20, and a larger portion of the resin layers 52,12 are present in a hermetic enclosure. This hermetic enclosure is formed by the passivation layers 35,55, that extends both on the resin layers 12, 52 and also adjacent thereto. The passivation layer 55 extends in the separation lanes 53, which evidently are present at all sides. The passivation layer 35 extends in a ring-shaped structure 38 through the resin layer 12 up to the oxide layer 11. It is particularly suitable to protect also larger portions of the resin layers 12,52, in that resin layers may easily absorb water and contaminants. This may give rise to swelling of the resin layers. Since the passivation layers 35,55 extends to the insulating layer 11, which is suitably of a similar nature, the adhesion thereto is good. Thus, the complete package is attached to the insulating layer 11, which appears to improve the stability of the package under high temperature, with a lesser extent of compressive stress. Stress as a consequence of differences in thermal expansion between the resin layers 12,52 and the passivation layers 35,55 may be released by deformation of the resin layers 12,52 in particular.

In short, the according to the invention, the flexible package 100 has between a first 1 and a second side 2 a semiconductor device 20 with a thinned back substrate 10 and an interconnect structure. Contact means 31,33 for external contact and a first resin layer 52 are present at the first side 2 of the package 100, which contact means 31,33 are coupled to the interconnect structure. At the second side 2 the semiconductor device 20 is at least substantially covered with a second resin layer 12. The contact means 31,33 are present on the first resin layer 52 and are coupled to the interconnect structure with redistribution tracks 32,34 extending through the first resin layer 52. A passivation layer 55 covers the first resin layer 52 and the redistribution tracks 32,34 at least substantially.

## Claims

1. A flexible semiconductor package (100) with a first (1) and a second side (2), between which sides (1,2) a semiconductor device (20) is present having a thinned back substrate (10) and an interconnect structure, at which first side (1) contact means (31,33) for external contact and a first resin layer (52) are present, which contact means (31,33) are coupled to the interconnect structure, and at which second side (2) the semiconductor device (20) is at least substantially covered with a second resin layer (12),
wherein the contact means (31,33) are present on the first resin layer (52) and are coupled to the interconnect structure with redistribution tracks (32,34) extending in apertures through the first resin layer (52), and a passivation layer (55) covers the first resin layer (52) and the redistribution tracks (32,34) at least substantially, **characterized in that** the redistribution tracks (32,34) do not fill the apertures of the first resin layer (52).

2. The flexible semiconductor package as claimed in claim 1, wherein the second resin layer (12) is also covered with a passivation layer (35).

3. The flexible semiconductor package as claimed in claim 2, wherein the semiconductor device is provided with a substrate (10) having an insulating layer (11), and the passivation layers (35,55) extend adjacent to and/or in apertures in the respective resin layer (12,52) up to the insulating layer (11), therewith forming a hermetic enclosure of the semiconductor device (20).

4. The package as claimed in claim 1, wherein the passivation layer (55,35) comprises an inorganic material.

5. The flexible semiconductor package as claimed in claim 1, wherein one of the resin layers (12, 52) is provided with rounded edges.

6. The package as claimed in claim 1, wherein the semiconductor device (20) is provided with a substrate side and an interconnect side, at which substrate side a semiconductor substrate (10) is present and at which interconnect side the interconnect structure is present, and wherein said first resin layer (52) is present at the substrate side and said second resin layer (12) is present at the interconnect side.

7. The flexible semiconductor package as claimed in claim 1, wherein the contact means are contact pads that are exposed through the passivation layer.

8. The flexible semiconductor package as claimed in claim 2, wherein at least one contact pad is present on the second resin layer and is exposed through an aperture in the passivation layer.

9. An assembly comprising the flexible semiconductor package as claimed in any one of claims 7-8 and a further electronic device being provided with contact pads that are coupled to the contact pads with bumps.

10. A method of manufacturing a plurality of semiconductor packages comprising the steps of:
- providing a wafer with a substrate side and an opposite, interconnect side and with a plurality of semiconductor devices, that are provided with an interconnect structure at the interconnect side;
- applying a resin layer on the interconnect structure;
- attaching the wafer with its first side to a carrier with an adhesive agent;
- thinning the wafer from the second side;
- applying another resin layer on the second side of the wafer, and
- removing at least some of the thus formed semiconductor packages from the carrier,
wherein contact means are defined on a first of the resin layers that are coupled to the interconnect structure with redistribution tracks extending through apertures in this first resin layer and that a passivation layer is applied on the first resin layer and the redistribution tracks, **characterized in that** the redistribution tracks do not fill the apertures of the first resin layer.

11. A method as claimed in claim 10, wherein the resin layer on the second side of the wafer is patterned to define separation lanes, and another passivation layer is applied on this patterned resin layer.

12. A method as claimed in claim 11, wherein the wafer is provided with an oxide layer, which is removed in the separation lanes before application of the said passivation layer.

13. A method as claimed in claim 11, wherein the resin layer on the second side of the wafer is patterned so as to have rounded edges at the separation lanes.

14. A method as claimed in claim 10, wherein the contact means are contact pads and solder is applied on the contact pads in the form of caps.

15. A method as claimed in claim 14, wherein the solder bumps are applied by immersion into a bath of a desired composition.

16. An intermediate product comprising a plurality of semiconductor packages as claimed in claim 1, wherein one of the resin layers is continuous between the packages, such that the packages can be individualized by dividing said resin layer.

17. A method of separation the intermediate product as claimed in claim 16 by dividing the said resin layer.

## Patentansprüche

1. Flexibles Halbleitergehäuse (100) mit einer ersten (1) und einer zweiten Seite (2), zwischen denen (1,2) sich eine Halbleiteranordnung (20) mit einem abgedünnten, rückseitigen Substrat (10) und einer Verbindungsstruktur befindet, wobei auf der ersten Seite (1) Kontaktmittel (31,33) zum externen Kontakt und eine erste Harzschicht (52) vorhanden sind, wobei die Kontaktmittel (31,33) an die Verbindungsstruktur gekoppelt sind, und wobei auf der zweiten Seite (2) die Halbleiteranordnung (20) zumindest im Wesentlichen mit einer zweiten Harzschicht (12) bedeckt ist,
wobei die Kontaktmittel (31,33) auf der ersten Harzschicht (52) vorgesehen und mit Redistributionsleiterbahnen (32,34), die sich in Öffnungen durch die erste Harzschicht (52) erstrecken, an die Verbindungsstruktur gekoppelt sind, und wobei eine Passivierungsschicht (55) die erste Harzschicht (52) und die Redistributionsleiterbahnen (32,34) zumindest im Wesentlichen bedeckt, **dadurch gekennzeichnet, dass** die Redistributionsleiterbahnen (32,34) die Öffnungen der ersten Harzschicht (52) nicht ausfüllen.

2. Flexibles Halbleitergehäuse nach Anspruch 1, wobei die zweite Harzschicht (12) ebenfalls mit einer Passivierungsschicht (35) bedeckt ist.

3. Flexibles Halbleitergehäuse nach Anspruch 2, wobei die Halbleiteranordnung mit einem Substrat (10) mit einer Isolationsschicht (11) versehen ist und die Passivierungsschichten (35,55) sich neben und in Öffnungen in der jeweiligen Harzschicht (12,52) bis zu der Isolationsschicht (11) erstrecken, womit eine hermetische Kapselung der Halbleiteranordnung (20) gebildet wird.

4. Gehäuse nach Anspruch 1, wobei die Passivierungsschicht (55,35) ein anorganisches Material aufweist.

5. Flexibles Halbleitergehäuse nach Anspruch 1, wobei eine der Harzschichten (12,52) mit gerundeten Kanten versehen ist.

6. Gehäuse nach Anspruch 1, wobei die Halbleiteranordnung (20) mit einer Substratseite und einer Verbindungsseite versehen ist, wobei sich auf der Substratseite ein Halbleitersubstrat und auf der Verbindungsseite die Verbindungsstruktur befindet, und
wobei die erste Harzschicht (52) auf der Substratseite und die zweite Harzschicht (12) auf der Verbindungsseite vorgesehen ist.

7. Flexibles Halbleitergehäuse nach Anspruch 1, wobei die Kontaktmittel Kontaktinseln sind, die durch die Passivierungsschicht exponiert werden.

8. Flexibles Halbleitergehäuse nach Anspruch 2, wobei sich mindestens eine Kontaktinsel auf der zweiten Harzschicht befindet und durch eine Öffnung in der Passivierungsschicht exponiert wird.

9. Anordnung mit dem flexiblen Halbleitergehäuse nach einem der Ansprüche 7-8 und einer weiteren elektronischen Anordnung, welche mit Kontaktinseln versehen ist, die an die Kontaktinseln mit Bondhügeln gekoppelt sind.

10. Verfahren zur Herstellung mehrerer Halbleitergehäuse, welches die folgenden Schritte umfasst:
- Versehen einer Halbleiterscheibe mit einer Substratseite und einer dieser gegenüberliegenden Verbindungsseite sowie mit mehreren Halbleiteranordnungen, welche auf der Verbindungsseite mit einer Verbindungsstruktur versehen sind,
- Aufbringen einer Harzschicht auf der Verbindungsstruktur,
- Befestigen der Halbleiterscheibe mit ihrer ersten Seite an einem Träger mit Hilfe eines Klebemittels,
- Abdünnen der Halbleiterscheibe von der zweiten Seite,
- Aufbringen einer weiteren Harzschicht auf der zweiten Seite der Halbleiterscheibe und
- Entfernen von zumindest einigen der damit ausgebildeten Halbleitergehäuse von dem Träger,
wobei Kontaktmittel auf einer ersten der Harzschichten definiert werden und mit sich durch diese erste Harzschicht erstreckenden Redistributionsleiterbahnen an die Verbindungsstruktur gekoppelt sind, und wobei eine Passivierungsschicht auf der ersten Harzschicht und den Redistributionsleiterbahnen aufgebracht wird, **dadurch gekennzeichnet, dass** die Redistributionsleiterbahnen die Öffnungen der ersten Harzschicht nicht ausfüllen.

11. Verfahren nach Anspruch 10, wobei die Harzschicht auf der zweiten Seite der Halbleiterscheibe strukturiert wird, um Trennungsstreifen zu definieren, und eine weitere Passivierungsschicht auf dieser strukturierten Harzschicht aufgebracht wird.

12. Verfahren nach Anspruch 10, wobei die Halbleiterscheibe mit einer Oxidschicht versehen wird, welche vor Aufbringen der Passivierungsschicht in den Trennungsstreifen entfernt wird.

13. Verfahren nach Anspruch 10 oder 11, wobei die Harzschicht auf der zweiten Seite der Halbleiterscheibe so strukturiert wird, dass diese an den Trennungsstreifen gerundete Kanten aufweist.

14. Verfahren nach Anspruch 10, wobei die Kontaktmittel Kontaktinseln sind und auf diese Kontaktinseln Lötmittel in Form von Abdeckkappen aufgebracht wird.

15. Zwischenprodukt mit mehreren Halbleitergehäusen nach Anspruch 1, wobei eine der Harzschichten zwischen den Gehäusen kontinuierlich verläuft, so dass die Gehäuse durch Teilen der Harzschicht vereinzelt werden können.

## Revendications

1. Boîtier semi-conducteur flexible (100) avec une première (1) et une deuxième face (2), faces (1, 2) entre lesquelles il est présent un dispositif à semi-conducteur (20) ayant un substrat arrière aminci (10) et une structure d'interconnexion, première face (1) à l'endroit de laquelle il est présent des moyens de contact (31, 33) pour le contact externe et une première couche de résine (52), lesquels moyens de contact (31, 33) sont couplés à la structure d'interconnexion et deuxième face (2) à l'endroit de laquelle le dispositif à semi-conducteur (20) est recouvert au moins sensiblement d'une deuxième couche de résine (12),
dans lequel les moyens de contact (31, 33) se situent sur la première couche de résine (52) et sont couplés à la structure d'interconnexion avec des pistes de redistribution (32, 34) s'étendant dans des ouvertures à travers la première couche de résine (52) et dans lequel une couche de passivation (55) recouvre au moins sensiblement la première couche de résine (52) et les pistes de redistribution (32, 34), **caractérisé en ce que** les pistes de redistribution (32, 34) ne remplissent pas les ouvertures de la première couche de résine (52).

2. Boîtier semi-conducteur flexible selon la revendication 1, dans lequel la deuxième couche de résine (12) est également recouverte d'une couche de passivation (35).

3. Boîtier semi-conducteur flexible selon la revendication 2, dans lequel le dispositif à semi-conducteur est pourvu d'un substrat (10) ayant une couche isolante (11) et
dans lequel les couches de passivation (35, 55) s'étendent d'une manière adjacente vers et/ou dans les ouvertures dans la couche respective de résine (12, 52) jusqu'à la couche isolante (11), de ce fait constituant une enceinte hermétique du dispositif à semi-conducteur (20).

4. Boîtier selon la revendication 1, dans lequel la couche de passivation (55, 35) comprend une matière inorganique.

5. Boîtier semi-conducteur flexible selon la revendication 1, dans lequel une des couches de résine (12, 52) est pourvue de bords arrondis.

6. Boîtier semi-conducteur flexible selon la revendication 1, dans lequel le dispositif à semi-conducteur (20) est pourvu d'un côté de substrat et d'un côté d'interconnexion, côté de substrat à l'endroit duquel il est présent un substrat semi-conducteur (10) et côté d'interconnexion à l'endroit duquel il est présent la structure d'interconnexion, et dans lequel ladite première couche de résine (52) se situe du côté de substrat et ladite deuxième couche de résine (12) se situe du côté d'interconnexion.

7. Boîtier semi-conducteur flexible selon la revendication 1, dans lequel les moyens de contact sont des patins de contact qui sont exposés par le biais de la couche de passivation.

8. Boîtier semi-conducteur flexible selon la revendication 2, dans lequel au moins un patin de contact se situe sur la deuxième couche de résine et est exposé par le biais d'une ouverture dans la couche de passivation.

9. Ensemble comprenant le boîtier semi-conducteur flexible selon l'une quelconque des revendications précédentes 7 à 8 et un nouveau autre dispositif électronique étant pourvu de patins de contact qui sont couplés aux patins de contact avec des bosses.

10. Procédé de fabrication d'une pluralité de boîtiers semi-conducteurs comprenant les étapes suivantes consistant à:
- pourvoir une tranche d'un côté de substrat et d'un côté opposé d'interconnexion et d'une pluralité de dispositifs à semi-conducteur qui sont pourvus d'une structure d'interconnexion du côté d'interconnexion;
- déposer une couche de résine sur la structure d'interconnexion;
- attacher la tranche avec son premier côté à un support au moyen d'un agent adhésif;
- amincir la tranche à partir du deuxième côté;
- déposer une autre couche de résine sur le deuxième côté de la tranche, et
- enlever au moins quelques-uns des boîtiers semi-conducteurs ainsi formés à partir du support,
dans lequel des moyens de contact sont définis sur une première des couches de résine qui sont couplées à la structure d'interconnexion au moyen de pistes de redistribution s'étendant à travers cette première couche de résine et qu'une couche de passivation est déposée sur la première couche de résine et sur les pistes de redistribution, **caractérisé en ce que** les pistes de redistribution ne remplissent pas les ouvertures de la première couche de résine.

11. Procédé selon la revendication 10, dans lequel la couche de résine du deuxième côté de la tranche est mise en configuration de manière à définir des voies de séparation et dans lequel une autre couche de passivation est déposée sur la couche de résine mise en configuration.

12. Procédé selon la revendication 10, dans lequel la tranche est pourvue d'une couche d'oxyde qui est enlevée des voies de séparation avant le dépôt de ladite couche de passivation.

13. Procédé selon la revendication 10 ou 11, dans lequel la couche de résine du deuxième côté de la tranche est mise en configuration de manière à avoir des bords arrondis à l'endroit des voies de séparation.

14. Procédé selon la revendication 10, dans lequel les moyens de contact sont des patins de contact et dans lequel de la soudure est appliquée sur les patins de contact sous forme de capsules.

15. Produit intermédiaire comprenant une pluralité de boîtiers semi-conducteurs selon la revendication 1, dans lequel une des couches de résine est continue entre les boîtiers de telle façon que les boîtiers puissent être individualisés par la division de ladite couche de résine.
